# FASCICULE DE BREVET EUROPEEN

(11) **EP 3 501 910 B1**
(45) Date de publication et mention de la délivrance du brevet: **06.08.2025**
(21) Numéro de dépôt: 18211651.7
(22) Date de dépôt: 11.12.2018
(51) Int. Cl.: B60R 16/023, H05K 5/00

(54) **ÉLÉMENT DE BOITIER POUR ÉQUIPEMENT ÉLECTRIQUE**
GEHÄUSEELEMENT FÜR ELEKTRISCHE AUSRÜSTUNG
HOUSING ELEMENT FOR ELECTRICAL EQUIPMENT

(30) Priorité: 22.12.2017 FR 1762952
(43) Date de publication de la demande: 26.06.2019
(73) Titulaire: Valeo Electrification, 95800 Cergy (FR)
(72) Inventeur: TRAMET, Guillaume, 78920 Ecquevilly (FR); DENIOT, Roger, 78300 Poissy (FR)
(74) Mandataire: Valeo Powertrain Systems

(56) Documents cités:
- EP-A1- 1 870 969
- EP-A1- 3 176 919
- DE-A1- 3 740 568
- FR-A1- 2 963 582
- US-A1- 2005 167 183
- US-A1- 2012 115 340
- US-A1- 2016 126 808

## Description

### DOMAINE TECHNIQUE ET OBJET DE L'INVENTION

La présente invention concerne un élément de boîtier pour un équipement électrique. La présente invention se rapporte plus particulièrement au domaine des équipements électriques haute tension pour véhicules électriques et hybrides.

L'invention vise notamment à permettre un assemblage aisé de conducteurs électriques sur un élément de boîtier d'un équipement électrique, notamment pour véhicule.

### ETAT DE LA TECHNIQUE

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension. La batterie d'alimentation haute tension assure une fonction d'alimentation en énergie du système de motorisation électrique permettant la propulsion du véhicule. Plus précisément, afin de commander la machine électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Dans une solution connue, l'onduleur se présente sous la forme d'un boîtier dans lequel sont montés un module électronique de puissance et une unité électronique de contrôle. L'onduleur comprend un corps comportant des composants électriques par lesquels passe l'énergie alimentant le moteur électrique. L'unité électronique de contrôle comprend des composants électroniques permettant de contrôler le module électronique de puissance.

Afin de connecter le module électronique de puissance à la batterie haute tension, le module électronique de puissance comprend un conducteur électrique dit « de potentiel positif » relié au potentiel positif de la batterie d'alimentation haute tension et un conducteur électrique dit « de potentiel négatif » relié au potentiel négatif de la batterie d'alimentation haute tension. En outre, dans le cas d'un moteur triphasé, l'onduleur comprend trois conducteurs électriques, dits « conducteurs de phase », permettant de relier le module électronique de puissance au moteur électrique afin de le commander en utilisant trois courants dits « de phase » déphasés deux à deux, par exemple de 120°, générés par l'onduleur à partir du courant continu délivré par la batterie haute tension.

Ces conducteurs de phase se présentent sous la forme de lames découpées puis pliées réalisées en un matériau électriquement conducteur, par exemple en cuivre. Les dimensions, notamment l'épaisseur, de ces conducteurs de phase, dépendent de l'intensité des courants qui les traversent. Ainsi, lorsque l'onduleur est utilisé pour commander la machine électrique entrainant les roues du véhicule, il est nécessaire d'utiliser des conducteurs de phase relativement épais (par exemple d'épaisseur supérieure à 2 mm) afin de permettre la circulation de courants de forte intensité, par exemple supérieure à 100A. En revanche, lorsque l'onduleur est utilisé pour stocker l'énergie produite par la machine électrique pendant un freinage du véhicule au niveau de la batterie d'alimentation haute tension, il est suffisant d'utiliser des conducteurs de phase dont l'épaisseur est moins importante, par exemple d'épaisseur inférieur à 1 mm, l'intensité des courants circulant dans les conducteurs de phase dans ce cas étant plus faible, par exemple inférieure à 50 A.

Dans une solution connue, les conducteurs de phase sont tout d'abord fixés au module de commande, par vissage sur le corps du module électronique de commande afin de les relier électriquement, puis surmoulés avec un élément du boîtier de l'onduleur réalisé en matériau plastique. Un tel procédé de fixation rend la fabrication de l'onduleur à la fois onéreux, complexe et chronophage, ce qui présente un inconvénient. Ensuite, ce procédé de fixation permanente ne permet pas d'optimiser la fabrication des onduleurs selon l'application à laquelle ils sont destinés, c'est-à-dire selon qu'ils sont susceptibles d'être utilisés pour commander la machine électrique ou bien pour stocker de l'énergie. Notamment, il n'est pas possible de changer de type de conducteur électrique selon l'application visée une fois les conducteurs surmoulés, ce qui présente un autre inconvénient.

Il existe donc un besoin d'une solution simple, fiable et efficace permettant de monter et de remplacer aisément différents types de conducteurs de phase, notamment d'épaisseurs différentes.

### PRESENTATION GENERALE DE L'INVENTION

A cet effet, l'invention a tout d'abord pour objet un élément de boîtier d'un équipement électrique, notamment pour véhicule électrique ou hybride, ledit élément de boîtier étant configuré pour recevoir au moins un conducteur électrique destiné à former une borne externe de l'équipement électrique et au moins un composant électronique de puissance, adapté pour être relié électriquement audit conducteur électrique, et notamment pour convertir un courant continue en un courant alternatif, ledit élément de boîtier étant remarquable en ce qu'il comprend des organes de réception adaptés pour recevoir, par coulissement, ledit conducteur électrique.

Le conducteur électrique peut être une lame métallique, de préférence pliée. Le conducteur électrique peut comprendre une première extrémité adaptée pour être connectée électriquement à un composant électronique de puissance et une deuxième extrémité adaptée pour être connectée électriquement à un deuxième équipement électrique, par exemple une machine électrique tel qu'un moteur électrique triphasé.

Les organes de réception permettent de réaliser une liaison de type liaison glissière avec le conducteur électrique. Une telle liaison permet de monter très facilement le conducteur sur l'élément de boîtier. En particulier, il est très aisé pour un opérateur d'insérer le conducteur électrique manuellement dans les organes de réception. L'utilisation de tels organes de réception permet notamment d'éviter de surmouler le conducteur électrique dans le matériau de l'élément de boîtier, ce qui permet à la fois de rendre la fabrication de l'équipement électrique plus simple et plus rapide et permet aussi une maintenance aisée dans la mesure où le conducteur électrique peut être retiré ou inséré très facilement de l'élément de boîtier. En outre, l'utilisation d'une liaison glissière permet de monter des conducteurs électriques à la fois de manière amovible et de différentes épaisseurs sur l'élément de boîtier, notamment selon l'application visée de l'équipement électrique et l'intensité des courants qui doivent circuler dans le conducteur électrique.

De préférence, les organes de réception comprennent au moins une paire de parois s'étendant parallèlement entre elles.

Dans une forme de réalisation, les organes de réception comprennent une pluralité de paires de parois, de préférence trois paires de parois, afin d'insérer trois conducteurs électriques permettant notamment de relier l'équipement électrique à une machine électrique triphasée.

De manière préférée, les parois de la pluralité de parois sont s'étendent parallèlement entre elles.

Selon un aspect de l'invention, chaque paire de parois comprend une première paroi et une deuxième paroi s'étendant parallèlement entre elles, la première paroi comprenant un rebord s'étendant en direction de la deuxième paroi, la deuxième paroi comprenant un rebord s'étendant en direction de la première paroi de manière à guider le coulissement du conducteur de phase. Pour chaque paire de parois, les parois et leurs rebords permettent ainsi de former deux rails de guidage et de maintien d'un conducteur électrique.

Avantageusement, les organes de réception comprennent au moins une butée configurée pour définir une fin de course pour le coulissement du conducteur électrique.

Les organes de réception sont configurés pour un montage à force du conducteur électrique. Un tel montage à force permet avantageusement de bloquer solidement le conducteur électrique dans l'élément de boîtier. Ce montage à force est réalisé en ajoutant des portions de blocage aux organes de réception. Ce montage à force peut être réalisé en adaptant l'épaisseur des rails de guidage et de maintien à l'épaisseur du conducteur électrique.

Avantageusement, au moins l'une de la première paroi et de la deuxième paroi comprend au moins un godron. Par le terme « godron », on entend une surépaisseur de matière ou une nervure qui sert à ajuster l'emboitement entre les organes de réception et les conducteurs de phase. L'utilisation de godrons permet un blocage efficace des conducteurs de phase suite à leur montage à force.

De manière avantageuse, chacune de la première paroi et de la deuxième paroi comprend au moins un godron afin de rendre le blocage davantage efficace.

De manière préféré, le au moins un godron est issu de matière de la première paroi ou de la deuxième paroi afin de rendre la fabrication de l'élément de boîtier aisée.

Selon un aspect de l'invention, l'élément de boîtier forme une paroi latérale, de préférence unique, d'un boîtier, les organes de réception étant situés sur ladite paroi latérale.

Avantageusement, les parois des organes de réception s'étendent depuis la paroi latérale perpendiculairement à ladite paroi latérale et les rebords s'étendent parallèlement à ladite paroi latérale afin d'assurer un blocage solide du conducteur électrique.

Selon un aspect de l'invention, la première paroi et la deuxième paroi de chaque couple de parois s'étendent sur au moins la moitié de la hauteur de la paroi latérale, de préférence sur au moins 80 % de la hauteur de la paroi latérale, de préférence encore sur au moins 90 % de la hauteur de la paroi latérale ou sur l'intégralité de la hauteur. Ceci permet d'assurer un blocage efficace de chaque conducteur de phase entre la première paroi et la deuxième paroi.

De manière préférée, cette ceinture présente au moins en partie une forme de U.

De manière préférée encore, les organes de réception sont issus de matière de la paroi latérale de manière à faciliter la fabrication de l'élément de boîtier, notamment par moulage.

De préférence encore, l'élément de boîtier est monobloc, ce qui le rend solide, aisé à manipuler lors de l'assemblage et aisé à fabriquer, notamment par moulage

Selon un aspect de l'invention, l'élément de boîtier est réalisé en un matériau plastique, ce qui le rend léger, solide et aisé à fabriquer, notamment par moulage. Notamment, l'élément de boitier est en un matériau isolant électriquement.

L'invention concerne également un équipement électrique, notamment pour véhicule électrique ou hybride, comprenant un élément de boîtier tel que présenté précédemment et au moins un conducteur électrique destiné à former une borne externe de l'équipement électrique, ledit conducteur électrique comportant une lame montée dans ledit élément de boitier par insertion dans les organes de réception de l'élément de boitier.

Avantageusement, l'équipement électrique comprend au moins un composant électronique de puissance ayant au moins une borne électrique et étant monté dans ledit élément de boîtier, équipement dans lequel le conducteur électrique comprend une portion centrale introduite dans les organes de réception, de laquelle s'étendent une première extrémité et une deuxième extrémité, la première extrémité étant fixée sur la borne électrique du composant électronique de puissance pour une connexion électrique, la deuxième extrémité formant une borne électrique externe de l'équipement électrique.

Avantageusement, l'équipement électrique comprend une pluralité de conducteurs électriques introduits dans des organes de réceptions respectifs et une pluralité de composants électroniques de puissance formant un module électronique de puissance, chaque conducteur électrique connectant une borne respective dudit module électronique de puissance.

Selon un aspect de l'invention, le module électronique de puissance est apte à convertir un courant continu en une pluralité de courants alternatifs dits « courants de phase », ladite pluralité de courants de phase circulant entre le module électronique de puissance et une machine électrique via la pluralité de conducteurs de phase. Par les termes « module électronique de puissance apte à convertir un courant continu en une pluralité de courants alternatifs », on entend que le module électronique de puissance peut être configuré pour convertir un courant continu en une pluralité de courant alternatifs et/ou pour convertir une pluralité de courant alternatifs en un courant continu.

De manière préférée, le module électronique comprend un corps.

Selon un aspect de l'invention, chaque conducteur électrique est fixé au corps du module électronique de puissance.

Avantageusement, le corps du module de puissance comprend des composants électriques par lesquels passe l'énergie alimentant le moteur électrique.

De préférence, l'équipement électrique est un onduleur destiné à être électriquement connecté à une machine électrique ou à une batterie d'alimentation haute tension via le conducteur électrique.

Selon un autre aspect de l'invention, l'équipement électrique comprend une unité électronique de contrôle dudit module électronique de puissance, couplée audit module électronique de puissance.

De manière avantageuse, l'unité électronique de contrôle comprend des composants électroniques permettant de contrôler ledit module électronique de puissance.

L'invention concerne aussi un véhicule électrique ou hybride comprenant une machine électrique, par exemple une machine de motorisation, alimentée par une batterie d'alimentation haute tension via un réseau électrique embarqué haute tension et un équipement électrique, tel que présenté précédemment, connecté à ladite machine électrique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 est une vue en perspective d'une forme de réalisation d'un onduleur selon l'invention,
- la figure 2 est une vue partielle en perspective de l'ensemble formé du module électronique, du premier conducteur électrique de potentiel positif, du premier conducteur électrique de potentiel négatif et de la barre de fixation de l'onduleur de la figure 1,
- la figure 3 est une vue en perspective d'un ensemble de conducteurs de phase,
- la figure 4 est une vue en perspective de l'élément de boîtier de l'onduleur de la figure 1,
- la figure 5 est une vue en perspective partielle rapprochée de l'élément de boîtier de la figure 4 montrant les organes de réception des conducteurs de phase de la figure 3,
- la figure 6 est une vue en perspective du montage de l'ensemble de conducteurs de phase de la figure 3 sur l'élément de boîtier de la figure 5,
- la figure 7 est une vue de dessus de l'élément de boîtier de la figure 5 sur lequel sont montés les conducteurs de phase de la figure 3,
- la figure 8 est une vue en perspective partielle rapprochée de l'élément de boîtier de la figure 7, et
- la figure 9 est une vue en perspective de l'élément de boîtier de la figure 5 sur lequel sont montés les conducteurs de phase de la figure 3.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention.

Dans l'exemple décrit ci-après, le véhicule comprend notamment une machine électrique, un équipement électrique se présentant sous la forme d'un onduleur, une batterie d'alimentation haute tension, un réseau électrique embarqué haute tension, une batterie d'alimentation basse tension, un réseau électrique embarqué basse tension et une pluralité d'équipements électriques auxiliaires.

L'équipement électrique selon l'invention est décrit ci-après dans sa mise en œuvre pour un onduleur, sans toutefois que cela ne limite la portée de la présente invention. On notera ainsi que l'équipement électrique pourrait être autre chose qu'un onduleur, par exemple un chargeur ou un convertisseur DCDC embarqués dans le véhicule.

Le réseau électrique embarqué basse tension relie la batterie d'alimentation basse tension et la pluralité d'équipements électriques auxiliaires afin que la batterie d'alimentation basse tension alimente lesdits équipements électriques auxiliaires, tels que des calculateurs embarqués, des moteurs de lève-vitres, un système multimédia, etc. La batterie d'alimentation basse tension délivre typiquement par exemple une tension de l'ordre de 12 V, 24 V ou 48 V. La recharge de la batterie basse tension est réalisée à partir de la batterie haute tension via un convertisseur de tension continue en tension continue, appelé communément convertisseur continu-continu.

Le réseau électrique embarqué haute tension relie la batterie d'alimentation haute tension et l'onduleur afin que la batterie d'alimentation haute tension assure une fonction d'alimentation en énergie de la machine électrique via l'onduleur. La batterie d'alimentation haute tension délivre typiquement une tension comprise entre 100 V et 900 V, de préférence entre 100 V et 500 V. La recharge en énergie électrique de la batterie d'alimentation haute tension est réalisée en la connectant, via le réseau électrique haute tension continue du véhicule, à un réseau électrique externe, par exemple le réseau électrique alternatif domestique.

La machine électrique est une machine électrique tournante, de préférence destinée à entrainer les roues du véhicule à partir de l'énergie fournie par la batterie d'alimentation haute-tension. Plus précisément, la machine électrique est une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention.

Dans cet exemple, la commande de la machine électrique est réalisée au moyen de l'onduleur. Ledit onduleur permet de convertir le courant continu fourni par la batterie d'alimentation haute tension en trois courants de commande alternatifs, par exemple sinusoïdaux. Autrement dit, l'onduleur a pour fonction de transformer le courant continu délivré en entrée par la batterie d'alimentation haute tension en trois courants de phase permettant de commander la machine électrique. A l'inverse, dans un autre mode de fonctionnement, la machine électrique peut également fournir trois courants alternatifs à l'onduleur afin que ledit onduleur les transforme en un courant continu permettant de charger la batterie d'alimentation haute-tension.

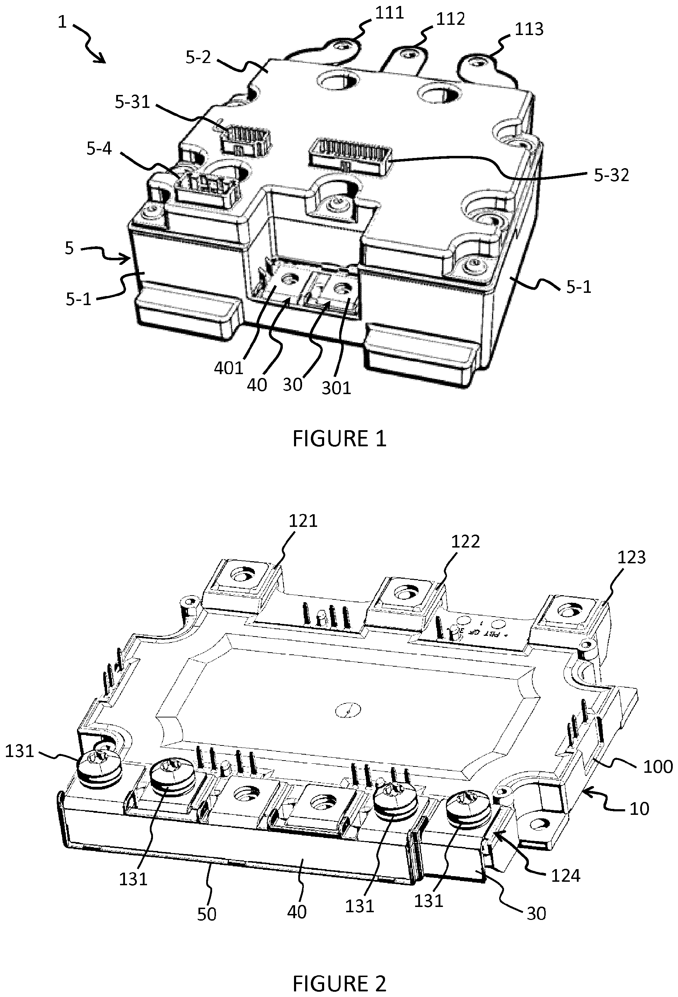

Dans l'exemple illustré à la figure 1, l'onduleur 1 comprend un boîtier 5 dans lequel sont montés, en référence à la figure 2, un module électronique de puissance 10, une unité électronique de contrôle (non représentée par souci de clarté) et une pluralité de conducteurs électriques 30, 40, 111, 112, 113. L'unité électronique de contrôle comprend des composants pour contrôler les composants du module électronique de puissance 10. Plus précisément, l'unité électronique de contrôle commande le module électronique de puissance 10 afin qu'il réalise la fonction de conversion du courant continu reçu de la batterie haute tension, définissant une tension continue entre le premier conducteur électrique 30 et le deuxième conducteur électrique 40, en trois courants de phase alternatifs de commande du moteur (ou vice-et-versa).

En référence aux figures 1 à 3, le module électronique de puissance 10 comprend un corps 100 sur lequel sont fixés les conducteurs électriques 30, 40, 111, 112, 113. Par ailleurs, le module électronique de puissance 10 comprend des composants électroniques de puissance par lesquels passe l'énergie alimentant la machine électrique, notamment destinés à transformer le courant continu en courants alternatifs ou vice-versa. Ces composants électroniques de puissance peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants électroniques de puissance sont des puces semiconductrices nues pour lesquels le corps 100 réalise une encapsulation. En référence à la figure 2, le module électronique de puissance 10 comprend neuf bornes électriques externes, formant en particulier d'une part trois ports de phase 121, 122, 123 délivrant chacun un courant de phase de commande du moteur et d'autre part trois bornes électriques externes positives 124 (dont une seule est visible sur la figure 2) et trois bornes électriques externes négatives (non visibles).

Dans l'exemple illustré aux figures 1 à 3, l'onduleur 1 comprend un premier conducteur électrique 30 destiné à relier électriquement l'onduleur 1 au potentiel positif de la batterie d'alimentation haute tension (non représentée), un deuxième conducteur électrique 40 destiné à relier électriquement l'onduleur 1 au potentiel négatif de la batterie d'alimentation haute tension et trois conducteurs dits « de phase » 111, 112, 113 destinés à relier électriquement l'onduleur 1 à la machine électrique.

En référence à la figure 2, chaque conducteur électrique 30, 40 se présente sous la forme d'une lame de laquelle s'étendent trois éléments de fixation 301, 401. Les deux éléments de fixation 301, 401 situés aux extrémités de chaque conducteur électrique 30, 40 permettent de fixer ledit conducteur électrique 30, 40 aux bornes électriques externes respectivement positives 124 et négatives correspondantes du module électronique de puissance 10 à l'aide d'une vis 131. Les orifices 301A, 401A des éléments de fixation 301, 401 centraux respectivement du premier conducteur électrique 30 et du deuxième conducteur électrique 40 sont laissés libres pour permettre de connecter ultérieurement les bornes positive et négative de la batterie d'alimentation haute tension. Comme illustré à la figure 2, l'onduleur 1 comprend en outre une barre de fixation 50 électriquement isolante séparant le premier conducteur électrique 30 du deuxième conducteur électrique 40, notamment afin de prévenir les courts-circuits entre le premier conducteur électrique 30 et le deuxième conducteur électrique 40. A cette fin, la barre de fixation 50 est réalisée de préférence en un matériau plastique tel que, par exemple, du PBT GF30.

Chaque conducteur de phase 111, 112, 113 permet de connecter électriquement une phase de la machine électrique commandée par l'onduleur 1 avec le module électronique de puissance 10. On notera que, dans une autre forme de réalisation, l'onduleur 1 pourrait comprendre un nombre de conducteurs de phase 111, 112, 113 différent, notamment un nombre fonction du nombre de phases de la machine électrique commandée par l'onduleur 1.

Chaque connecteur de phase 111, 112, 113 est monté sur le port de phase 121, 122, 123 correspondant par l'intermédiaire d'un moyen de fixation, par exemple une vis (non représentée). Chaque conducteur de phase 111, 112, 113 traverse une ouverture du boîtier 5 pour permettre de relier l'onduleur 1 à la machine électrique et notamment permettre la circulation des courants alternatifs entre le module électronique de puissance 10 et la machine électrique.

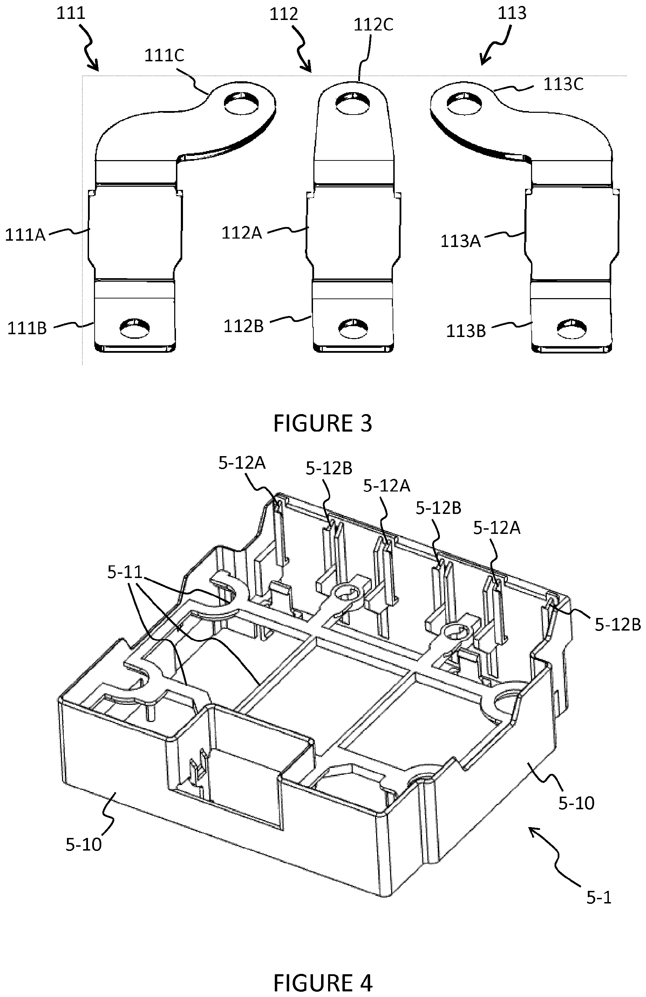

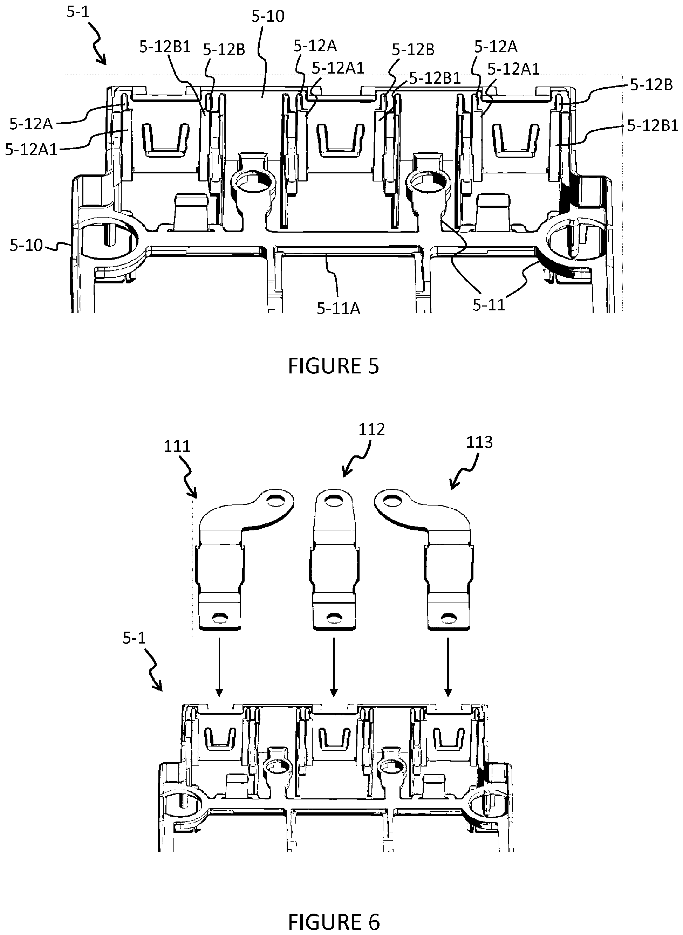

En référence maintenant aux figures 3 et 6, chaque conducteur de phase 111, 112, 113 se présente sous la forme d'une pièce monobloc, c'est-à-dire réalisées d'un seul tenant. Cette pièce se présente sous la forme d'une lame formée en la conformant dans un même matériau électriquement conducteur. Dans cet exemple préféré, le conducteur de phase 111, 112, 113 est réalisé en un matériau conducteur électrique, par exemple, en cuivre, en acier, en aluminium.

L'épaisseur des conducteurs de phase 111, 112, 113 peut être choisie en fonction de l'utilisation qui en est faite et notamment de l'intensité des courants qui la parcourt. Avantageusement, l'épaisseur des conducteurs de phase 111, 112, 113 est comprise entre 0,5 et 3 mm. De préférence, l'épaisseur du conducteur de phase 111, 112, 113 est de l'ordre de 1 mm, 1,5 mm ou 2 mm. Les conducteurs de phase 111, 112, 113 peuvent en outre avantageusement être recouverts d'un traitement de surface anti-usure, par exemple composé d'étain et/ou de nickel pour la compatibilité des matériaux ou améliorer le courant électrique.

Dans l'exemple illustré sur les figures, chaque conducteur électrique 111, 112, 113 comprend une portion centrale 111A, 112A, 113A de laquelle s'étendent perpendiculairement mais dans une direction opposée une première extrémité de fixation 111B, 112B, 113B, et une deuxième extrémité de fixation 111C, 112C, 113C. La première extrémité de fixation 111B, 112B, 113B est destinée à être reliée à un port de phase 121, 122, 123 du module électronique de puissance 10, par exemple à l'aide d'une vis. A cette fin, la première extrémité de fixation 111B, 112B, 113B se présente sous la forme d'une portion plane adaptée pour venir en contact avec une portion plane d'un port de phase 121, 122, 123. La deuxième extrémité de fixation 111C, 112C, 113C est destinée à être reliée à un conducteur de phase (non représenté) de la machine électrique. A cette fin, la deuxième extrémité de fixation 111C, 112C, 113C se présente également sous la forme d'une portion plane adaptée pour venir en contact avec une portion plane d'un conducteur de phase de la machine électrique.

On notera que, dans cet exemple non limitatif, les deuxièmes extrémités 111C, 113C des conducteurs de phase 111 et 113 sont conformées de sorte à se rapprocher de la deuxième extrémité 112C du conducteur de phase 112 positionné au centre, qui se situe dans le prolongement de la portion centrale 112A dudit conducteur de phase 112 central. Ceci a pour effet de rapprocher les deuxièmes extrémités 111C, 112C, 113C des conducteurs de phase 111, 112, 113 afin de les connecter avec des conducteurs de phase correspondants, agencés similairement, de la machine électrique. Cependant, les deuxièmes extrémités 111C, 112C, 113C peuvent être formées différemment, notamment en fonction de l'environnement dans lequel l'onduleur 1 va être monté.

Comme illustré sur la figure 1, le boîtier 5 comprend un élément de boîtier 5-1 et un couvercle 5-2, monté sur l'élément de boîtier 5. Le boîtier 5 comprend également un fond (non visible sur la figure 1) s'étendant sous l'élément de boîtier 5-1. Dans l'exemple illustré à la figure 1, l'onduleur 1 comprend en outre, de manière non limitative, deux connecteurs de signaux 5-31, 5-32 et un connecteur d'alimentation 5-4, montés sur le couvercle 5-2 du boîtier 5. Les connecteurs de signaux 5-31, 5-32 sont destinés à permettre un échange de signaux de données entre les composants de l'onduleur 1 et l'extérieur de l'onduleur 1, par exemple avec un contrôleur du véhicule. En particulier, ces connecteurs de signaux 5-31, 5-32 peuvent être connectés à une unité électronique de contrôle (non représentée) montée dans l'élément de boîtier 5-1. Le connecteur d'alimentation 5-4, est destiné à connecter l'onduleur 1 à un câble d'alimentation électrique, par exemple relié au réseau électrique embarqué basse tension, afin de permettre l'alimentation électrique de ladite unité électronique de contrôle.

En référence désormais à la figure 4, l'élément de boîtier 5-1 se présente sous la forme d'une pièce monobloc réalisée par moulage d'un matériau plastique isolant électriquement. L'élément de boîtier 5-1 comprend une paroi latérale 5-10 se présentant sous la forme d'une ceinture en forme de U et des éléments de support 5-11 configuré pour recevoir le module électronique de puissance 10 et l'unité électronique de contrôle. Dans cet exemple, les éléments de support 5-11 comprennent notamment des longerons 5-11A permettant de réceptionner le corps 100 du module électronique de puissance 10 et l'unité électronique de contrôle.

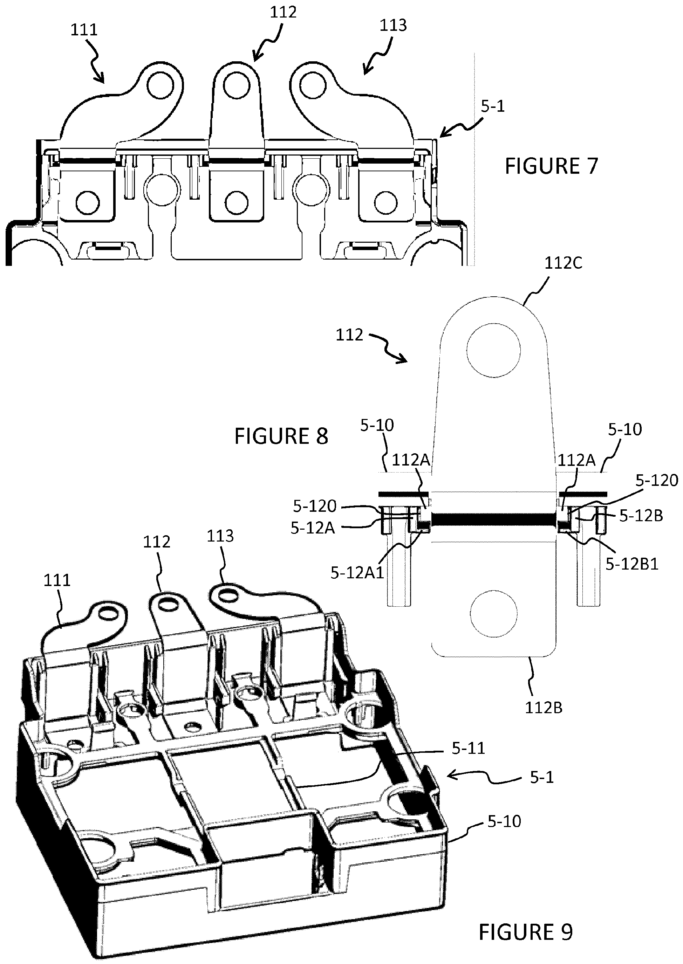

En référence aux figures 5 à 9, l'élément de boîtier 5 comprend des organes de réception, permettant de bloquer, dans cet exemple par montage à force, les conducteurs de phase 111, 112, 113. Ces organes de réception sont issus de matière de la paroi latérale 5-10 et comprennent trois paires de rails adaptées chacune pour recevoir un conducteur de phase 111, 112, 113.

Plus précisément, chaque paire de rails comprend une première paroi 5-12A et une deuxième paroi 5-12B s'étendant parallèlement entre elles et perpendiculairement à la paroi latérale 5-10 de manière à bloquer un conducteur de phase 111, 112, 113. Dans cet exemple, la première paroi 5-12A et la deuxième paroi 5-12B de chaque paire de parois 5-12A, 5-12B s'étendent sensiblement sur toute la hauteur de la paroi latérale 5-10.

De préférence, chacune de la première paroi 5-12A et de la deuxième paroi 5-12B de chaque paire de parois 5-12A, 5-12B comprend au moins un godron 5-120. Un tel godron 5-120 constitue une surépaisseur de matière qui sert à ajuster l'emboitement entre chaque paire de parois 5-12A, 5-12B et le conducteur de phase 111, 112, 113 correspondant de manière à les bloquer efficacement l'un dans l'autre. Dans cet exemple, les godrons 5-120 sont issus de matière de la première paroi 5-12A et de la deuxième paroi 5-12B de chaque paire de parois 5-12A, 5-12B.

Toujours dans l'exemple illustré, la première paroi 5-12A comprend un rebord 5-12A1, s'étendant parallèlement à la paroi latérale 5-10 en direction de la deuxième paroi 5-12B, et la deuxième paroi 5-12B comprend également un rebord 5-12B1, s'étendant parallèlement à la paroi latérale 5-10 en direction de la première paroi 5-12A.

Lors de l'assemblage de l'onduleur, le module électronique de puissance 10 et l'unité électronique de contrôle sont d'abord assemblés.

Chaque conducteur de phase 111, 112, 113 est ensuite monté à force par glissement entre chaque paire de parois 5-12A, 5-12B de sorte à être bloqués par les godrons entre la première paroi 5-12A et la deuxième paroi 5-12B de chaque paire de parois 5-12A, 5-12B.

Ensuite, chaque conducteur de phase 111, 112, 113 est vissé sur le port de phase 121, 122, 123 correspondant de manière à le relier électriquement aux ports de phase 121, 122, 123 du module électronique de puissance 10.

Les rebords 5-12A1, 5-12B1 des parois 5-12A, 5-12B permettent de guider et maintenir les conducteurs de phase 111, 112, 113 entre la première paroi 5-12A et la deuxième paroi 5-12B.

Le couvercle 5-2 et le fond du boîtier 5 peuvent ensuite être fixés sur l'élément de boîtier 5-1 de manière à fermer le boîtier et rendre l'onduleur 1 étanche. Les conducteurs de phase 111, 112, 113 de l'onduleur 1 peuvent ensuite être connectés électriquement à la machine électrique de même que les conducteurs électriques de potentiel positif et négatif 30, 40 peuvent être connectés électriquement à la batterie haute tension du véhicule.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuvent-être indépendantes entre elles d'un mode à l'autre, ou combinées entre elles, comme cela ressort des revendications.

## Revendications

1. Elément de boîtier (5-1) d'un équipement électrique (1), ledit élément de boîtier (5-1) étant configuré pour recevoir au moins un conducteur électrique (111, 112, 113) destiné à former une borne externe de l'équipement électrique et ledit élément de boîtier (5-1) comprenant des organes de réception (5-12A, 5-12B) adaptés pour recevoir, par coulissement, le conducteur électrique (111, 112, 113), ledit élément de boîtier (5-1) étant **caractérisé en ce qu'**il est configuré pour recevoir au moins un composant électronique de puissance, adapté pour être relié électriquement au conducteur électrique (111, 112, 113), et **en ce que** lesdits organes de réception (5-12A, 5-12B) sont configurés pour un montage à force du conducteur électrique (111, 112, 113), en ajoutant des portions de blocage dans les organes de réception (5-12A, 5-12B).

2. Elément de boîtier (5-1) selon la revendication 1, dans lequel les organes de réception comprennent au moins une paire de parois (5-12A, 5-12B) s'étendant parallèlement entre elles.

3. Elément de boîtier (5-1) selon la revendication précédente, dans lequel la paire de parois (5-12A, 5-12B) comprend une première paroi (5-12A) et une deuxième paroi (5-12B) s'étendant parallèlement entre elles, la première paroi (5-12A) comprenant un rebord (5-12A1) s'étendant en direction de la deuxième paroi (5-12B), la deuxième paroi (5-12B) comprenant un rebord (5-12B1) s'étendant en direction de la première paroi (5-12A) de manière à guider le coulissement du conducteur de phase (111, 112, 113).

4. Elément de boîtier (5-1) selon l'une des revendications précédentes, dans lequel les organes de réception comprennent au moins une butée (5-120) configurée pour définir une fin de course pour le coulissement du conducteur électrique (111, 112, 113).

5. Elément de boîtier (5-1) selon l'une des revendications précédentes, dans lequel, ledit élément de boîtier (5-1) forme une paroi latérale d'un boîtier (5-10), les organes de réception (5-12A, 5-12B) étant situés sur ladite paroi latérale (5-10).

6. Elément de boîtier (5-1) selon la revendication précédente et la revendication 3, dans lequel les parois (5-12A, 5-12B) s'étendent depuis la paroi latérale (5-10) perpendiculairement à ladite paroi latérale (5-10) et les rebords (5-12A1, 5-12B1) s'étendent parallèlement à ladite paroi latérale (5-10).

7. Elément de boîtier (5-1) selon la revendication précédente, dans lequel la première paroi (5-12A) et la deuxième paroi (5-12B) s'étendent sur au moins la moitié de la hauteur de la paroi latérale (5-10).

8. Equipement électrique (1), comprenant un élément de boîtier (5-1) selon l'une des revendications précédentes et au moins un conducteur électrique (111, 112, 113) destiné à former une borne externe de l'équipement électrique (1), ledit conducteur électrique (111, 112, 113) comportant une lame montée dans ledit élément de boitier (5-1) par insertion dans les organes de réception (5-12A, 5-12B) de l'élément de boitier (5-1).

9. Equipement électrique (1) selon la revendication précédente, comprenant au moins un composant électronique de puissance (10) ayant au moins une borne électrique (121, 122, 123) et étant monté dans ledit élément de boîtier (5-1), équipement dans lequel le conducteur électrique (111, 112, 113) comprend une portion centrale (111A, 112A, 113A) introduite dans les organes de réception, de laquelle s'étendent une première extrémité (111B, 112B, 113B) et une deuxième extrémité (111C, 112C, 113C), la première extrémité (111B, 112B, 113B) étant fixée sur la borne électrique (121, 122, 123) du composant électronique de puissance (10) pour une connexion électrique, la deuxième extrémité (111C, 112C, 113C) formant une borne électrique externe de l'équipement électrique (1).

10. Equipement électrique selon l'une des revendications 8 ou 9, comprenant une pluralité de conducteurs électriques (111, 112, 113) introduits dans des organes de réception (5-12A, 5-12B) respectifs et une pluralité de composants électroniques de puissance formant un module électronique de puissance (10), chaque conducteur électrique (111, 112, 113) connectant une borne respective dudit module électronique de puissance (10).

11. Equipement électrique (1) selon l'une des revendications 8 à 10, ledit équipement électrique étant un onduleur (1) destiné à être électriquement connecté à une machine électrique via le conducteur électrique.

## Patentansprüche

1. Gehäuseelement (5-1) einer elektrischen Vorrichtung (1), wobei das Gehäuseelement (5-1) so konfiguriert ist, dass es mindestens einen elektrischen Leiter (111, 112, 113) zur Bildung eines externen Anschlusses der elektrischen Ausrüstung aufzunehmen, wobei das Gehäuseelement (5-1) Aufnahmeelemente (5-12A, 5-12B) umfasst, die dazu ausgelegt sind, den elektrischen Leiter (111, 112, 113) verschiebbar aufzunehmen, wobei das Gehäuseelement (5-1) **dadurch gekennzeichnet ist, dass** es zur Aufnahme mindestens einer elektronischen Leistungskomponente ausgebildet ist, die zur elektrischen Verbindung mit dem elektrischen Leiter (111, 112, 113) geeignet ist, und dass die Aufnahmeelemente (5-12A, 5-12B) so ausgebildet sind, dass sie den elektrischen Leiter (111, 112, 113) durch Hinzufügen von Verriegelungsabschnitten in den Aufnahmeelementen (5-12A, 5-12B) fest einpassen.

2. Gehäuseteil (5-1) nach Anspruch 1, wobei die Aufnahmeelemente mindestens ein Paar Wände (5-12A, 5-12B) umfassen, die sich parallel zueinander erstrecken.

3. Gehäuseteil (5-1) nach dem vorherigen Anspruch, wobei das Paar Wände (5-12A, 5-12B) eine erste Wand (5-12A) und eine zweite Wand (5-12B) umfasst, die sich parallel zueinander erstrecken, wobei die erste Wand (5-12A) einen Flansch (5-12A1) umfasst, der sich in Richtung der zweiten Wand (5-12B) erstreckt, wobei die zweite Wand (5-12B) einen Flansch (5-12B1) aufweist, der sich in Richtung der ersten Wand (5-12A) erstreckt, um die Verschiebung des Phasenleiters (111, 112, 113) zu führen.

4. Gehäuseteil (5-1) nach einem der vorstehenden Ansprüche, wobei die Aufnahmeelemente mindestens einen Anschlag (5-120) umfassen, der so ausgebildet ist, dass er ein Ende des Verschiebungswegs des elektrischen Leiters (111, 112, 113) definiert.

5. Gehäuseteil (5-1) nach einem der vorstehenden Ansprüche, wobei das Gehäuseteil (5-1) eine Seitenwand eines Gehäuses (5-10) bildet, wobei die Aufnahmeelemente (5-12A, 5-12B) an der Seitenwand (5-10) angeordnet sind.

6. Gehäuseteil (5-1) nach dem vorherigen Anspruch und nach Anspruch 3, wobei sich die Wände (5-12A, 5-12B) von der Seitenwand (5-10) senkrecht zu dieser erstrecken und die Flansche (5-12A1, 5-12B1) erstrecken sich parallel zu der Seitenwand (5-10).

7. Gehäuseteil (5-1) nach dem vorherigen Anspruch, wobei die erste Wand (5-12A) und die zweite Wand (5-12B) sich über mindestens die Hälfte der Höhe der Seitenwand (5-10) erstrecken.

8. Elektrische Vorrichtung (1), umfassend ein Gehäuseelement (5-1) gemäß einem der vorstehenden Ansprüche und mindestens einen elektrischen Leiter (111, 112, 113) zur Bildung eines externen Anschlusses der elektrischen Vorrichtung (1), wobei der elektrische Leiter (111, 112, 113) eine Klinge aufweist, die durch Einführen in die Aufnahmeelemente (5-12A, 5-12B) des Gehäuseelements (5-1) in diesem Gehäuseelement (5-1) angebracht ist.

9. Elektrische Vorrichtung (1) nach dem vorstehenden Anspruch, mit mindestens einem elektronischen Leistungsbauteil (10), das mindestens einen elektrischen Anschluss (121, 122, 123) aufweist und in dem Gehäuseelement (5-1) montiert ist, wobei der elektrische Leiter (111, 112, 113) einen mittleren Abschnitt (111A, 112A, 113A), der in die Aufnahmeelemente eingeführt ist und von dem sich ein erstes Ende (111B, 112B, 113B) und ein zweites Ende (111C, 112C, 113C) erstrecken, wobei das erste Ende (111B, 112B, 113B) ist zur elektrischen Verbindung an der elektrischen Klemme (121, 122, 123) des elektronischen Leistungsbauteils (10) befestigt, wobei das zweite Ende (111C, 112C, 113C) eine externe elektrische Klemme der elektrischen Ausrüstung (1) bildet.

10. Elektrische Vorrichtung nach einem der Ansprüche 8 oder 9, mit einer Vielzahl von elektrischen Leitern (111, 112, 113), die in jeweilige Aufnahmeelemente (5-12A, 5-12B) eingeführt sind, und einer Vielzahl von elektronischen Leistungsbauteilen, die ein elektronisches Leistungsmodul (10) bilden, wobei jeder elektrische Leiter (111, 112, 113) einen jeweiligen Anschluss des elektronischen Leistungsmoduls (10) verbindet.

11. Elektrische Ausrüstung (1) nach einem der Ansprüche 8 bis 10, wobei die elektrische Ausrüstung ein Wechselrichter (1) ist, der über den elektrischen Leiter elektrisch mit einer elektrischen Maschine verbunden werden soll.

## Claims

1. Housing element (5-1) of electrical equipment (1), said housing element (5-1) being configured to receive at least one electrical conductor (111, 112, 113) intended to form an external terminal of the electrical equipment, and said housing element (5-1) comprising receiving members (5-12A, 5-12B) adapted to receive, by sliding, the electrical conductor (111, 112, 113), said housing element (5-1) being **characterised in that** it is configured to receive at least one power electronic component, adapted to be electrically connected to the electrical conductor (111, 112, 113), and **in that** said receiving members (5-12A, 5-12B) are configured for force-fitting of the electrical conductor (111, 112, 113) by adding blocking portions in the receiving members (5-12A, 5-12B).

2. Housing member (5-1) according to claim 1, wherein the receiving members comprise at least a pair of walls (5-12A, 5-12B) extending parallel to each other.

3. Housing member (5-1) according to the preceding claim, wherein the pair of walls (5-12A, 5-12B) comprise a first wall (5-12A) and a second wall (5-12B) extending parallel to each other, the first wall (5-12A) comprising a flange (5-12A1) extending towards the second wall (5-12B), the second wall (5-12B) comprising a flange (5-12B1) extending towards the first wall (5-12A) so as to guide the sliding of the phase conductor (111, 112, 113).

4. Housing element (5-1) according to one of the preceding claims, wherein the receiving members comprise at least one stop (5-120) configured to define an end of travel for the sliding of the electrical conductor (111, 112, 113).

5. Housing member (5-1) according to one of the preceding claims, wherein said housing member (5-1) forms a side wall of a housing (5-10), the receiving members (5-12A, 5-12B) being located on said side wall (5-10).

6. Housing member (5-1) according to the preceding claim and claim 3, wherein the walls (5-12A, 5-12B) extend from the side wall (5-10) perpendicular to said side wall (5-10) and the flanges (5-12A1, 5-12B1) extend parallel to said side wall (5-10).

7. Housing element (5-1) according to the preceding claim, wherein the first wall (5-12A) and the second wall (5-12B) extend over at least half the height of the side wall (5-10).

8. Electrical equipment (1), comprising a housing element (5-1) according to one of the preceding claims and at least one electrical conductor (111, 112, 113) intended to form an external terminal of the electrical equipment (1), said electrical conductor (111, 112, 113) comprising a blade mounted in said housing element (5-1) by insertion into the receiving members (5-12A, 5-12B) of the housing element (5-1).

9. Electrical equipment (1) according to the previous claim, comprising at least one power electronic component (10) having at least one electrical terminal (121, 122, 123) and being mounted in said housing element (5-1), equipment in which the electrical conductor (111, 112, 113) comprises a central portion (111A, 112A, 113A) introduced into the receiving members, from which extend a first end (111B, 112B, 113B) and a second end (111C, 112C, 113C), the first end (111B, 112B, 113B) being fixed to the electrical terminal (121, 122, 123) of the power electronic component (10) for electrical connection, the second end (111C, 112C, 113C) forming an external electrical terminal of the electrical equipment (1).

10. Electrical equipment according to one of claims 8 or 9, comprising a plurality of electrical conductors (111, 112, 113) introduced into respective receiving members (5-12A, 5-12B) and a plurality of power electronic components forming a power electronic module (10), each electrical conductor (111, 112, 113) connecting a respective terminal of said power electronic module (10).

11. Electrical equipment (1) according to one of claims 8 to 10, said electrical equipment being an inverter (1) intended to be electrically connected to an electrical machine via the electrical conductor.
